# EUROPEAN PATENT APPLICATION

(11) **EP 4 811 972 A1**
(43) Date of publication of application: **23.09.2026**
(21) Application number: 25835812.6
(22) Date of filing: 29.04.2025
(51) Int. Cl.: H10F 77/1223, H10F 77/14, H10F 10/14

(54) **SOLAR CELL, SOLAR MODULE, AND PHOTOVOLTAIC SYSTEM**

(30) Priority: 12.07.2024 CN 202410940051
(71) Applicant: Zhejiang Aiko Solar Energy Technology Co., Ltd., Yiwu, Jinhua Zhejiang 322000 (CN); Tianjin Aiko Solar Energy Technology Co., Ltd., Tianjin 300400 (CN); Zhuhai Fushan Aiko Solar Energy Technology Co., Ltd., FushanIndustrial Park, Doumen District Zhuhai Guangdong 519000 (CN); Guangdong Aiko Solar Energy Technology Co., Ltd., Foshan, Guangdong 528000 (CN); Shenzhen Aiko Digital Energy Technology Co., Ltd., Shenzhen, Guangdong 518000 (CN)
(72) Inventor: YANG, Xinqiang, Jinhua, Zhejiang 322000 (CN); ZHANG, Shengli, Jinhua, Zhejiang 322000 (CN); WANG, Yongqian, Jinhua, Zhejiang 322000 (CN); CHEN, Gang, Jinhua, Zhejiang 322000 (CN)
(74) Representative: EP&C
(86) International application number: PCT/CN2025/092152
(87) International publication number: WO 2026/011908

(57) **Abstract**

The present disclosure is applicable to the technical field of solar cells, and provides a solar cell, a cell module, and a photovoltaic system. The solar cell includes: a silicon substrate, including a first region and a second region, where the first region and the second region are located on the same surface or on two opposite surfaces of the silicon substrate; a P-type doped polysilicon layer, at least formed on the first region; and an N-type doped polysilicon layer, at least formed on the second region, where both the P-type doped polysilicon layer and the N-type doped polysilicon layer contain metal impurities; the metal impurities include at least one of iron, copper, cobalt, nickel, and chromium; the N-type doped polysilicon layer includes a first portion close to the silicon substrate, and the P-type doped polysilicon layer includes a third portion close to the silicon substrate; and a concentration of at least one of the metal impurities in the first portion is greater than a concentration of the same metal impurity in the third portion. An impurity absorption effect of the N-type doped polysilicon layer of the solar cell of the present disclosure is better than an impurity absorption effect of the P-type doped polysilicon layer, so that it is conductive to prolonging the life of minority carriers in the solar cell and improving cell efficiency.

## Description

### Cross-Reference to Related Application

The present disclosure is based on Chinese patent application No. 202410940051.6, filed on July 12, 2024 and entitled "Solar Cell, Cell Module, and Photovoltaic System", which is incorporated into this application by reference in its entirety.

### Technical Field

The present disclosure relates to the technical field of solar cell, and in particular, to a solar cell, a cell module, and a photovoltaic system.

### Background

Solar cells use a photovoltaic effect of a semiconductor to convert the sunlight into electrical energy. The solar cells mainly include bifacial solar cells and back-contact solar cells. Compared with the bifacial solar cell, due to the positive/negative electrode the back-contact solar cell both designed on a back surface of the cell, so that blocking caused by a metal grid on a front surface of the back-contact solar cell is completely avoided, thus eliminating an optical loss caused by the blocking caused by the metal grid and greatly improving conversion efficiency of the cell.

In the related art, metal impurities such as iron, copper, cobalt, nickel, and chromium in a silicon substrate of a solar cell have a significant impact on a P-type doped polysilicon layer and a small impact on an N-type doped polysilicon layer. Since the existing solar cell usually does not consider a difference between absorption of the N-type doped polysilicon layer on the metal impurities in the silicon substrate and absorption of the P-type doped polysilicon layer on the metal impurities in the silicon substrate, a metal impurity removal effectiveness on the silicon substrate is poor, which is not conducive to prolonging the minority carrier lifetime in the solar cell, resulting in low cell efficiency.

### Summary

The present disclosure provides a solar cell, and aims to solve the problem of low cell efficiency because the solar cell in the related art has a poor impurity absorption effect on impurities of a silicon substrate, which is not conductive to prolonging the minority carrier lifetime in the solar cell.

The present disclosure is implemented below: A solar cell is provided, including:
a silicon substrate, including a first region and a second region, where the first region and the second region are located on the same surface of the silicon substrate, or the first region and the second region are respectively located on two opposite surfaces of the silicon substrate;
a P-type doped polysilicon layer, at least formed on the first region; and
an N-type doped polysilicon layer, at least formed on the second region,
wherein both the P-type doped polysilicon layer and the N-type doped polysilicon layer contain metal impurities; the metal impurities include at least one of iron, copper, cobalt, nickel, and chromium; the N-type doped polysilicon layer includes a first portion close to the silicon substrate, and the P-type doped polysilicon layer includes a third portion close to the silicon substrate; and a concentration of at least one of the metal impurities in the first portion is greater than a concentration of the same metal impurity in the third portion.

In some implementations, the N-type doped polysilicon layer includes a second portion away from the silicon substrate, and the P-type doped polysilicon layer includes a fourth portion away from the silicon substrate; and a concentration of at least one of the metal impurities in the second portion is greater than a concentration of the same metal impurity in the fourth portion.

In some implementations, the concentration of the at least one of the metal impurities in the first portion is greater than the concentration of the same metal impurity in the second portion.

In some implementations, the concentration of the at least one of the metal impurities in the third portion is greater than the concentration of the same metal impurity in the fourth portion.

In some implementations, the concentration of the metal impurities in the first portion of the N-type doped polysilicon layer is 0.1 to 100 PPBW.

In some implementations, the concentration of the metal impurities in the first portion of the N-type doped polysilicon layer is 10 to 100 PPBW.

In some implementations, the concentration of the metal impurities in the first portion of the N-type doped polysilicon layer is 30 to 100 PPBW.

In some implementations, the concentration of the at least one of the metal impurities in the first portion is greater than the concentration of the same metal impurity in the silicon substrate.

In some implementations, a ratio of a concentration of a metal impurity in the first portion to a concentration of the same metal impurity in the third portion is 1.5 to 100.

In some implementations, the solar cell further includes:
a first tunneling layer, provided between the silicon substrate and the P-type doped polysilicon layer; and
a second tunneling layer, provided between the silicon substrate and the N-type doped polysilicon layer,
wherein a thickness of the second tunneling layer is less than a thickness of the first tunneling layer.

In some implementations, the thickness of the second tunneling layer is 0.1 to 0.9 times the thickness of the first tunneling layer.

In some implementations, both the second tunneling layer and the first tunneling layer are provided with pores, and a pore density of the second tunneling layer is greater than a pore density of the first tunneling layer.

In some implementations, both the second tunneling layer and the first tunneling layer are provided with pores, and an average size of the pores in the second tunneling layer is greater than an average size of the pores in the first tunneling layer.

In some implementations, an area of the N-type doped polysilicon layer is larger than an area of the P-type doped polysilicon layer.

In some implementations, an area of the N-type doped polysilicon layer is 1 to 10 times an area of the P-type doped polysilicon layer.

In some implementations, a thickness of the N-type doped polysilicon layer is greater than a thickness of the P-type doped polysilicon layer.

In some implementations, a thickness of the N-type doped polysilicon layer is 1 to 10 times a thickness of the P-type doped polysilicon layer.

In some implementations, the solar cell is a back-contact solar cell, and the first region and the second region are located on the same surface of the silicon substrate.

In some implementations, the solar cell is a bifacial solar cell, and the first region and the second region are respectively located on two opposite surfaces of the silicon substrate.

In some implementations, the silicon substrate includes a first surface and a second surface opposite to the first surface; the first surface is arranged with a plurality of the first regions and a plurality of third regions; the first region and the third region are alternately arranged in sequence; the second surface is arranged with a plurality of the second regions and a plurality of fourth regions; the second region and the fourth region are alternately arranged in sequence; the P-type doped polysilicon layer is arranged on the first regions and does not cover the third regions; and the N-type doped polysilicon layer is arranged on the second regions and does not cover the fourth regions.

The present disclosure further provides a cell module, including the above solar cell.

The present disclosure further provides a photovoltaic system, including the above cell module.

According to the solar cell provided by the present disclosure, the concentration of at least one metal impurity in the first portion of the N-type doped polysilicon layer close to the silicon substrate is greater than the concentration of the same metal impurity in the third portion of the P-type doped polysilicon layer close to the silicon substrate. That is, metal impurities entering the first portion of the N-type doped polysilicon layer from the silicon substrate are more than metal impurities entering the third portion of the P-type doped polysilicon layer from the silicon substrate, so that an impurity absorption effect of the N-type doped polysilicon layer on the silicon substrate is better than an impurity absorption effect of the P-type doped polysilicon layer. This can reduce an adverse effect caused by the metal impurities in the silicon substrate on the N-type doped polysilicon layer and the P-type doped polysilicon layer, and it is convenient for the doped polysilicon layer to absorb the metal impurities in the silicon substrate and is conductive to prolonging the minority carrier lifetime of the cell, thereby improving cell efficiency.

### Brief Description of the Drawings

Fig. 1 is a schematic diagram of a solar cell according to Embodiment I of the present disclosure; and
Fig. 2 is a schematic diagram of a solar cell according to Embodiment II of the present disclosure.

Descriptions of reference numerals of main elements:
1: silicon substrate; 10: second passivation layer; 11: first surface; 12: second surface; 111: first region; 112: third region; 121: second region; 122: fourth region; 2: P-type doped polysilicon layer; 21: third portion; 22: fourth portion; 3: N-type doped polysilicon layer; 31: first portion; 32: second portion; 4: first tunneling layer; 5: second tunneling layer; 6: first electrode; 7: second electrode; 8: rear-side passivation layer; and 9: first passivation layer.

### Detailed Description of the Embodiments

In order to make the objectives, technical solutions, and advantages of the present disclosure clearer, the following is a further detailed explanation of the present disclosure in conjunction with the accompanying drawings and embodiments. It should be understood that the specific embodiments described herein are merely used to explain the present disclosure but are not intended to limit the present disclosure.

According to the solar cell provided by the embodiments of the present disclosure, the concentration of at least one metal impurity in the first portion of the N-type doped polysilicon layer close to the silicon substrate is greater than the concentration of the same metal impurity in the third portion of the P-type doped polysilicon layer close to the silicon substrate. That is, metal impurities entering the first portion of the N-type doped polysilicon layer from the silicon substrate are more than metal impurities entering the third portion of the P-type doped polysilicon layer from the silicon substrate, so that an impurity absorption effect of the N-type doped polysilicon layer on the silicon substrate is better than an impurity absorption effect of the P-type doped polysilicon layer. This can reduce an adverse effect caused by the metal impurities in the silicon substrate on the N-type doped polysilicon layer and the P-type doped polysilicon layer, and it is convenient for the doped polysilicon layer to absorb the metal impurities in the silicon substrate and is conductive to prolonging the minority carrier lifetime of the cell, thereby improving cell efficiency.

### Embodiment I

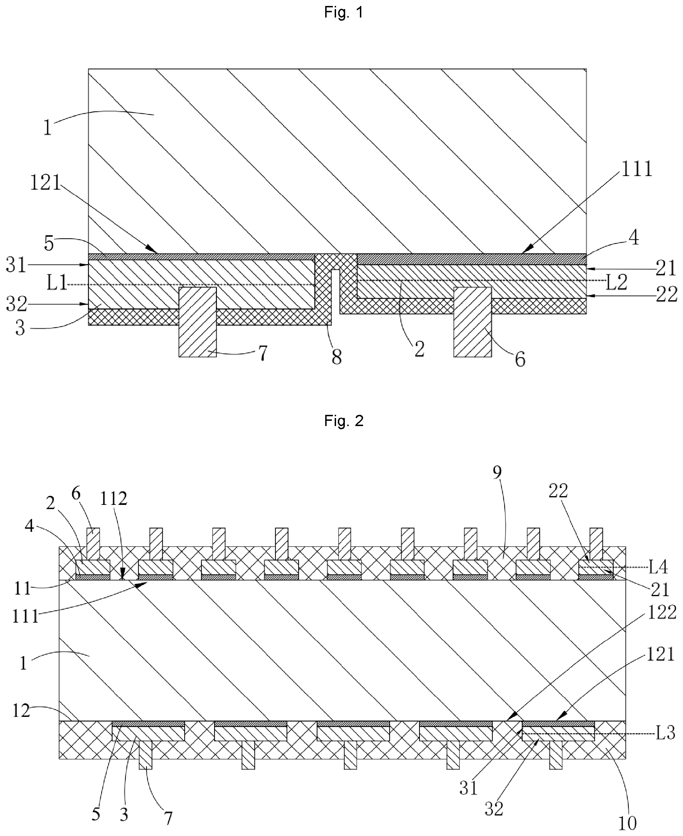

Referring to Fig. 1, a solar cell according to an embodiment of the present disclosure includes:
a silicon substrate 1, including a first region 111 and a second region 121, where the first region 111 and the second region 121 are located on the same surface of the silicon substrate 1;
a P-type doped polysilicon layer 2, at least formed on the first region 111; and
an N-type doped polysilicon layer 3, at least formed on the second region 121.

Both the P-type doped polysilicon layer 2 and the N-type doped polysilicon layer 3 contain metal impurities. The metal impurities include at least one of iron, copper, cobalt, nickel, and chromium. The N-type doped polysilicon layer 3 includes a first portion 31 close to the silicon substrate 1, and the P-type doped polysilicon layer 2 includes a third portion 21 close to the silicon substrate 1. A concentration of at least one of the metal impurities in the first portion 31 is greater than a concentration of the same metal impurity in the third portion 21.

In this embodiment of the present disclosure, the solar cell is a back-contact solar cell, and the first region 111 and the second region 121 are located on the same surface of the silicon substrate 1. That is, the first region 111 and the second region 121 are located on a shaded surface of the silicon substrate 1. The P-type doped polysilicon layer 2 is formed on the first region 111. In some implementations, the P-type doped polysilicon layer 2 is arranged in a region other than the first region 111. The N-type doped polysilicon layer 3 is formed on the second region 121. In some other implementations, the N-type doped polysilicon layer 3 is arranged in a region other than the second region 121.

In this embodiment of the present disclosure, the N-type doped polysilicon layer 3 is divided in its thickness direction into a first portion 31 close to the silicon substrate 1 and a second portion 32 away from the silicon substrate 1. The P-type doped polysilicon layer 2 is divided in its thickness direction into a third portion 21 close to the silicon substrate 1 and a fourth portion 22 away from the silicon substrate 1. The dashed line L1 in Fig. 1 is only to distinguish the first portion 31 and the second portion 32 of the N-type doped polysilicon layer 3, and the dashed line L2 is to distinguish the third portion 21 and the fourth portion 22 of the P-type doped polysilicon layer 2. The dashed line L1 and the dashed line L2 in Fig. 1 do not actually exist.

In this embodiment of the present disclosure, in some implementations, the thickness of the first portion 31 of the N-type doped polysilicon layer 3 and the thickness of the second portion 32 of the N-type doped polysilicon layer 3 are equal. In some other implementations, the thickness of the first portion 31 of the N-type doped polysilicon layer 3 and the thickness of the second portion 32 of the N-type doped polysilicon layer 3 are not equal, and specific thicknesses of the first portion 31 and the second portion 32 are not limited. In some implementations, the thickness of the third portion 21 of the P-type doped polysilicon layer 2 and the thickness of the fourth portion 22 of the P-type doped polysilicon layer 2 are equal. In some other implementations, the thickness of the third portion 21 of the P-type doped polysilicon layer 2 and the thickness of the fourth portion 22 of the P-type doped polysilicon layer 2 are not equal, and specific thicknesses of the third portion 21 and the fourth portion 22 are not limited.

In this embodiment of the present disclosure, both the P-type doped polysilicon layer 2 and the N-type doped polysilicon layer 3 contain metal impurities. The metal impurities include at least one of iron, copper, cobalt, nickel, and chromium. A concentration of at least one of the metal impurities in the first portion 31 is greater than a concentration of the same metal impurity in the third portion 21. It can be understood that when the same metal impurities in the first portion 31 and the third portion 21 are compared, the concentration of at least one of the metal impurities in the first portion 31 is greater than the concentration of the corresponding same metal impurity in the third portion 21. For example, the concentration of the iron in the first portion 31 is greater than the concentration of the iron in the third portion 21, the concentration of the copper in the first portion 31 is greater than the concentration of the copper in the third portion 21, the concentration of the nickel in the first portion 31 is greater than the concentration of the nickel in the third portion 21.In some implementations, the concentrations of the various metal impurities in the first portion 31 are greater than the concentrations of the same metal impurities in the third portion 21. That is, the concentration of each metal impurity in the first portion 31 is greater than the concentration of the metal impurity in the third portion 21.

In this embodiment of the present disclosure, since the metal impurities such as iron, copper, cobalt, nickel, and chromium in the silicon substrate 1 have a smaller impact on the N-type doped polysilicon layer 3 than the P-type doped polysilicon layer 2, in some implementations, an impurity absorption effect on the silicon substrate 1 is improved by increasing an impurity absorption effect of the N-type doped polysilicon layer 3. That is, an impurity absorption ability of the N-type doped polysilicon layer 3 on the silicon substrate 1 is higher than an impurity absorption ability of the P-type doped polysilicon layer 2, so that the concentration of the same metal impurity in the N-type doped polysilicon layer 3 is greater than the concentration of the same metal impurity in the P-type doped polysilicon layer 2. Therefore, the concentrations of the metal impurities in the first portion 31 of the N-type doped polysilicon layer 3 are greater than the concentrations of the metal impurities in the third portion 21 of the P-type doped polysilicon layer 2. It is conductive to prolonging the minority carrier lifetime of the cell, thereby improving cell efficiency.

In this embodiment of the present disclosure, the impurity absorption effect of the N-type doped polysilicon layer 3 is enhanced specifically by adjusting a doping concentration of the N-type doped polysilicon layer 3, a doping diffusion temperature of the N-type doped polysilicon layer 3, a thickness of the N-type doped polysilicon layer 3, a grain size of the N-type doped polysilicon layer 3, or the like, so that the impurity absorption effect of the N-type doped polysilicon layer 3 is better than the impurity absorption effect of the P-type doped polysilicon layer 2, and the concentrations of the metal impurities in the first portion 31 of the N-type doped polysilicon layer 3 are greater than the concentrations of the metal impurities in the third portion 21 of the P-type doped polysilicon layer 2. That is, more metal impurities such as iron, copper, cobalt, nickel, and chromium in the silicon substrate 1 enter the N-type doped polysilicon layer 3, so that the adverse effect of the metal impurities on the N-type doped polysilicon layer 3 and the P-type doped polysilicon layer 2 is reduced, and it is conductive to absorption of the doped polysilicon layers on the metal impurities in the silicon substrate 1, thereby prolonging the minority carrier lifetime of the cell and improving cell efficiency.

In some embodiments of the present disclosure, the N-type doped polysilicon layer 3 includes a second portion 32 away from the silicon substrate 1. The P-type doped polysilicon layer 2 includes a fourth portion 22 close to the silicon substrate 1. A concentration of at least one of the metal impurities in the second portion 32 is greater than a concentration of the same metal impurity in the fourth portion 22.

In this embodiment, the concentration of the at least one of the metal impurities in the second portion 32 is greater than the concentration of the same metal impurity in the fourth portion 22. It can be understood that when the same metal impurities in the second portion 32 and the fourth portion 22 are compared, the concentration of the at least one of the metal impurities in the second portion 32 is greater than the concentration of the corresponding same metal impurity in the fourth portion 22. For example, the concentration of the iron in the second portion 32 is greater than the concentration of the iron in the fourth portion 22, the concentration of the copper in the second portion 32 is greater than the concentration of the copper in the fourth portion 22, the concentration of the nickel in the second portion 32 is greater than the concentration of the nickel in the fourth portion 22. In some implementations, the concentrations of the various metal impurities in the second portion 32 are greater than the concentrations of the same metal impurities in the fourth portion 22. That is, the concentration of each metal impurity in the second portion 32 is greater than the concentration of the metal impurity in the fourth portion 22.

In this embodiment, since the impurity absorption effect of the N-type doped polysilicon layer 3 is better than the impurity absorption effect of the P-type doped polysilicon layer 2, the concentrations of the metal impurities in the second portion 32 of the N-type doped polysilicon layer 3 are also greater than the concentrations of the metal impurities in the fourth portion 22 of the P-type doped polysilicon layer 2. This can further enhance the impurity absorption effect of the N-type doped polysilicon layer 3.

In some embodiments of the present disclosure, the concentration of the at least one of the metal impurities in the first portion 31 is greater than the concentration of the same metal impurity in the second portion 32.

In this embodiment, the concentration of the at least one of the metal impurities in the first portion 31 is greater than the concentration of the same metal impurity in the second portion 32. It can be understood that when the same metal impurities in the first portion 31 and the second portion 32 are compared, the concentration of at least one of the metal impurities in the first portion 31 is greater than the concentration of the corresponding same metal impurity in the second portion 32. For example, the concentration of the iron in the first portion 31 is greater than the concentration of the iron in the second portion 32, the concentration of the copper in the first portion 31 is greater than the concentration of the copper in the second portion 32, the concentration of the nickel in the first portion 31 is greater than the concentration of the nickel in the second portion 32. In some implementations, the concentrations of the various metal impurities in the first portion 31 are greater than the concentrations of the same metal impurities in the second portion 32. That is, the concentration of each metal impurity in the first portion 31 is greater than the concentration of the metal impurity in the second portion 32.

In this embodiment, since the first portion 31 of the N-type doped polysilicon layer 3 is closer to the silicon substrate 1 than the second portion 32, the concentrations of the metal impurities in the first portion 31 are greater than the concentrations of the metal impurities in the second portion 32 of the N-type doped polysilicon layer 3.

In some embodiments of the present disclosure, the concentration of the at least one of the metal impurities in the third portion 21 is greater than the concentration of the same metal impurity in the fourth portion 22.

In this embodiment, the concentration of the at least one of the metal impurities in the third portion 21 is greater than the concentration of the same metal impurity in the fourth portion 22. It can be understood that when the same metal impurities in the third portion 21 and the fourth portion 22 are compared, the concentration of the at least one of the metal impurities in the second portion 21 is greater than the concentration of the corresponding same metal impurity in the fourth portion 22. For example, the concentration of the iron in the third portion 21 is greater than the concentration of the iron in the fourth portion 22, the concentration of the copper in the third portion 21 is greater than the concentration of the copper in the fourth portion 22, the concentration of the nickel in the third portion 21 is greater than the concentration of the nickel in the fourth portion 22. In some implementations, the concentrations of the various metal impurities in the third portion 21 are greater than the concentrations of the same metal impurities in the fourth portion 22. That is, the concentration of each metal impurity in the third portion 21 is greater than the concentration of the metal impurity in the fourth portion 22.

In this embodiment, since the third portion 21 of the P-type doped polysilicon layer 2 is closer to the silicon substrate 1 than the fourth portion 22, the concentrations of the metal impurities in the third portion 21 are greater than the concentrations of the metal impurities in the fourth portion 22.

In some embodiments of the present disclosure, the concentration of the metal impurities in the first portion 31 of the N-type doped polysilicon layer 3 is 0.1 to 100 PPBW.

In some implementations, the concentrations that represent the metal impurities are specifically measured by using an inductively coupled plasma mass spectrometry (ICP-MS).

In this embodiment, the concentrations of the metal impurities in the first portion 31 of the N-type doped polysilicon layer 3 are 0.1-100 PPBW. It can be understood that the concentrations of the various metal impurities in the first portion 31 of the N-type doped polysilicon layer 3 are 0.1 to 100 PPBW. The metal impurities such as iron, copper, cobalt, nickel, and chromium in the silicon substrate 1 enter the N-type doped polysilicon layer 3, and the concentrations of the metal impurities in the N-type doped polysilicon layer 3 are 0.1 to 100 PPBW.

In some embodiments of the present disclosure, the concentration of the metal impurities in the first portion 31 of the N-type doped polysilicon layer 3 is 10 to 100 PPBW.

In this embodiment, the metal impurities such as iron, copper, cobalt, nickel, and chromium in the silicon substrate 1 enter the N-type doped polysilicon layer 3, and the concentrations of the metal impurities in the N-type doped polysilicon layer 3 are 10 to 100 PPBW. This further increases the concentrations of the metal impurities in the N-type doped polysilicon layer 3 and improves the impurity absorption ability of the N-type doped polysilicon layer 3.

In some embodiments of the present disclosure, the concentration of the metal impurities in the first portion 31 of the N-type doped polysilicon layer 3 is 30 to 100 PPBW.

In this embodiment, the concentrations of the metal impurities in the N-type doped polysilicon layer 3 are further increased, and the impurity absorption ability of the N-type doped polysilicon layer 3 is further improved.

In some embodiments of the present disclosure, the concentration of the metal impurities in the first portion 31 of the N-type doped polysilicon layer 3 is 1 × 10¹¹ to 8 × 10¹³ atoms/cm³. The concentrations that represent the metal impurities are measured by using a secondary ion mass spectrometry (SIMS) or another higher-precision measuring instrument.

In this embodiment, the concentration of the metal impurities in the first portion 31 of the N-type doped polysilicon layer 3 is 1 × 10¹¹ to 8 × 10¹³ atoms/cm³. It can be understood that the concentrations of the various metal impurities in the first portion 31 of the N-type doped polysilicon layer 3 are within a range of 1 × 10¹¹ to 8 × 10¹³ atoms/cm³. The metal impurities such as iron, copper, cobalt, nickel, and chromium in the silicon substrate 1 enter the first portion 31 of the N-type doped polysilicon layer 3, so that the concentrations of the metal impurities in the first portion 31 of the N-type doped polysilicon layer 3 are 1 × 10¹¹ to 8 × 10¹³ atoms/cm³.

In some embodiments of the present disclosure, the concentrations of the metal impurities in the third portion 21 of the P-type doped polysilicon layer 2 is 0.6×10¹¹ to 5×10¹³ atoms/cm³. The concentrations that represent the metal impurities are measured by using a secondary ion mass spectrometry (SIMS) or another higher-precision measuring instrument.

The metal impurities such as iron, copper, cobalt, nickel, and chromium in the silicon substrate 1 enter the third portion 21 of the P-type doped polysilicon layer 2, so that the concentrations of the metal impurities in the third portion 21 of the P-type doped polysilicon layer 2 are 0.6×10¹¹ to 5×10¹³ atoms/cm³.

In some embodiments of the present disclosure, the concentration of the at least one of the metal impurities in the first portion 31 is greater than the concentration of the same metal impurity in the silicon substrate 1.

In this embodiment, the concentration of the at least one of the metal impurities in the first portion 31 is greater than the concentration of the same metal impurity in the silicon substrate 1. It can be understood that when the same metal impurities in the first portion 31 and the silicon substrate 1 are compared, the concentration of at least one of the metal impurities in the first portion 31 is greater than the concentration of this metal impurity in the silicon substrate 1. For example, the concentration of the iron in the first portion 31 is greater than the concentration of the iron in the silicon substrate 1. The concentration of the copper in the first portion 31 is greater than the concentration of the copper in the silicon substrate 1. The concentration of the nickel in the first portion 31 is greater than the concentration of the nickel in the silicon substrate 1. In some implementations, the concentrations of the various metal impurities in the first portion 31 are greater than the concentrations of the same metal impurities in the silicon substrate 1. That is, the concentration of each metal impurity in the first portion 31 is greater than the concentration of the metal impurity in the silicon substrate 1. That is, more metal impurities in the silicon substrate 1 are absorbed into the N-type doped polysilicon layer 3, thus achieving a good impurity absorption effect on the silicon substrate 1.

In some embodiments of the present disclosure, a ratio of a concentration of a metal impurity in the first portion 31 to a concentration of the same metal impurity in the third portion 21 is 1.5 to 100.

In this embodiment, the ratio of the concentration of the metal impurity in the first portion 31 to the concentration of the same metal impurity in the third portion 21 is 1.5 to 100. It can be understood that when the same metal impurities in the first portion 31 and the third portion 21 are compared, the ratio of the concentration of the metal impurity in the first portion 31 to the concentration of the metal impurity in the third portion 21 is 1.5 to 100. Therefore, the impurity absorption ability of the N-type doped polysilicon layer 3 is 1.5 to 100 times the impurity absorption ability of the P-type doped polysilicon layer 2, thereby effectively improving the impurity absorption ability of the N-type doped polysilicon layer 3 compared with the impurity absorption ability of the P-type doped polysilicon layer 2.

Further, the ratio of the concentration of the metal impurity in the first portion 31 to the concentration of the same metal impurity in the third portion 21 is 10 to 100.

In some implementations, a ratio of a concentration of a metal impurity in the first portion 31 to a concentration of the same metal impurity in the third portion 21 is 50 to 100.

In some embodiments of the present disclosure, the solar cell further includes:
a first tunneling layer 4, provided between the silicon substrate 1 and the P-type doped polysilicon layer 2; and
a second tunneling layer 5, provided between the silicon substrate 1 and the N-type doped polysilicon layer 3,
wherein a thickness of the second tunneling layer 5 is less than a thickness of the first tunneling layer 4.

In this embodiment, the first tunneling layer 4 and the second tunneling layer 5 achieve tunneling passivation, which can improve cell efficiency. Since the thickness of the second tunneling layer 5 is less than the thickness of the first tunneling layer 4, it is advantageous for more impurities in the silicon substrate 1 to enter the N-type doped polysilicon layer 3 through the second tunneling layer 5, thereby enhancing the impurity absorption effect.

In some embodiments of the present disclosure, the thickness of the second tunneling layer 5 is 0.1 to 0.9 times the thickness of the first tunneling layer 4.

In this embodiment, the thickness of the second tunneling layer 5 is 0.1 to 0.9 times the thickness of the first tunneling layer 4. This not only facilitates the impurities in the silicon substrate 1 to enter the N-type doped polysilicon layer 3 through the second tunneling layer 5, but also makes the second tunneling layer 5 and the first tunneling layer 4 maintain good tunneling passivation.

In some embodiments of the present disclosure, both the second tunneling layer 5 and the first tunneling layer 4 have pores, and a pore density of the second tunneling layer 5 is greater than a pore density of the first tunneling layer 4.

In this embodiment, the pore density of the second tunneling layer 5 is greater than the pore density of the first tunneling layer 4, so that it can be understood that a quantity of the pores in the second tunneling layer 5 is greater than a quantity of the pores in the first tunneling layer 4 per unit area. Since the pore density of the second tunneling layer 5 is greater than the pore density of the first tunneling layer 4, it can be more convenient for the impurities to enter the N-type doped polysilicon layer 3 through the second tunneling layer 5, and it is conductive to enhancing the impurity absorption effect of the N-type doped polysilicon layer 3 and improving cell efficiency.

In some embodiments of the present disclosure, both the second tunneling layer 5 and the first tunneling layer 4 have pores, and an average size of the pores in the second tunneling layer 5 is greater than an average size of the pores in the first tunneling layer 4.

In some implementations, pore diameters of the pores in the second tunneling layer 5 are equal. In some other implementations, pore diameters of the pores in the second tunneling layer 5 are not equal. Similarly, in some implementations, pore diameters of the pores in the first tunneling layer 4 are equal. In some other implementations, pore diameters of the pores in the first tunneling layer 4 are not equal. An average pore diameter of the pores in the second tunneling layer 5 can be understood as an average pore diameter of all the pores in the second tunneling layer 5. An average pore diameter of the pores in the first tunneling layer 4 can be understood as an average pore diameter of all the pores in the first tunneling layer 4. Since the average pore diameter of the second tunneling layer 5 is set to be greater than the average pore diameter of the first tunneling layer 4, it is convenient for the impurities to enter the N-type doped polysilicon layer 3 through the second tunneling layer 5, and it is conductive to enhancing the impurity absorption effect of the N-type doped polysilicon layer 3 and improving cell efficiency.

In some embodiments of the present disclosure, an area of the N-type doped polysilicon layer 3 is larger than an area of the P-type doped polysilicon layer 2.

In this embodiment, since the area of the N-type doped polysilicon layer 3 is larger than the area of the P-type doped polysilicon layer 2, a region of the silicon substrate 1 covered by the N-type doped polysilicon layer 3 can be enlarged. It is convenient for more impurities in the silicon substrate 1 to enter the N-type doped polysilicon layer 3, thereby enhancing the impurity absorption effect of the N-type doped polysilicon layer 3 and improving cell efficiency.

In some embodiments of the present disclosure, the area of the N-type doped polysilicon layer 3 is 1 to 10 times the area of the P-type doped polysilicon layer 2.

In this embodiment, a ratio of the area of the N-type doped polysilicon layer 3 to the area of the P-type doped polysilicon layer 2 is: 1.01, or 1.5, or 2.0, or 2.4, or 3.0, or 3.5, or 4, or 4.5, or 5, or 5.5, or 6, or 6.5, or 7, or 7.5, or 8, or 8.5, or 9, or 9.5, or 10.

In some embodiments of the present disclosure, the area of the N-type doped polysilicon layer 3 is 3 to 10 times the area of the P-type doped polysilicon layer 2. This can further increase a difference between the area of the N-type doped polysilicon layer 3 and the area of the P-type doped polysilicon layer 2, and is conductive to enhancing the impurity absorption effect of the N-type doped polysilicon layer 3.

In some embodiments of the present disclosure, a width of the N-type doped polysilicon layer 3 is greater than a width of the P-type doped polysilicon layer 2.

In this embodiment, a length of the N-type doped polysilicon layer 3 is equal to a length of the P-type doped polysilicon layer 2, and the width of the N-type doped polysilicon layer 3 is greater than the width of the P-type doped polysilicon layer 2. Therefore, the area of the N-type doped polysilicon layer 3 is larger than the area of the P-type doped polysilicon layer 2, so that a region of the silicon substrate 1 covered by the N-type doped polysilicon layer 3 can be enlarged. It is convenient for more impurities in the silicon substrate 1 to enter the N-type doped polysilicon layer 3, thereby enhancing the impurity absorption effect of the N-type doped polysilicon layer 3 and improving cell efficiency.

In some embodiments of the present disclosure, a thickness of the N-type doped polysilicon layer 3 is greater than a thickness of the P-type doped polysilicon layer 2.

In this embodiment, since the thickness of the N-type doped polysilicon layer 3 is greater than the thickness of the P-type doped polysilicon layer 2, a volume of the N-type doped polysilicon layer 3 can be increased, thereby further improving the impurity absorption ability of the N-type doped polysilicon layer. It is convenient for more impurities in the silicon substrate 1 to enter the N-type doped polysilicon layer 3, thereby enhancing the impurity absorption effect of the N-type doped polysilicon layer 3 and improving cell efficiency.

In some embodiments of the present disclosure, the thickness of the N-type doped polysilicon layer 3 is 1 to 10 times the thickness of the P-type doped polysilicon layer 2.

In this embodiment, a ratio of the thickness of the N-type doped polysilicon layer 3 to the thickness of the P-type doped polysilicon layer 2 is greater than 1 and less than or equal to 10. The ratio of the thickness of the N-type doped polysilicon layer 3 to the thickness of the P-type doped polysilicon layer 2 is: 1.01, or 1.5, or 2.0, or 2.4, or 3.0, or 3.5, or 4, or 4.5, or 5, or 5.5, or 6, or 6.5, or 7, or 7.5, or 8, or 8.5, or 9, or 9.5, or 10.

In a preferred embodiment of the present disclosure, the thickness of the N-type doped polysilicon layer 3 is 3 to 10 times the thickness of the P-type doped polysilicon layer 2, which can further increase a difference between the thickness of the N-type doped polysilicon layer 3 and the thickness of the P-type doped polysilicon layer 2, and is conductive to enhancing the impurity absorption effect of the N-type doped polysilicon layer 3.

In some embodiments of the present disclosure, the solar cell further includes:
a first electrode 6, which is in contact with the P-type doped polysilicon layer 2; and
a second electrode 7, which is in contact with the N-type doped polysilicon layer 3.

In some embodiments of the present disclosure, the solar cell further includes:
a rear-side passivation layer 8 that covers the P-type doped polysilicon layer 2 and the N-type doped polysilicon layer 3, wherein the first electrode 6 is in contact with the P-type doped polysilicon layer 2 through the rear-side passivation layer 8, and the second electrode 7 is in contact with the N-type doped polysilicon layer 3 through the rear-side passivation layer 8.

In this embodiment, the rear-side passivation layer 8 includes at least one of or a combination of more of an aluminum oxide film layer, a silicon oxide film layer, a silicon nitride film layer, a silicon carbide film layer, and a silicon nitride oxide film layer. For example, in some embodiments, the rear-side passivation layer 8 can include the aluminum oxide film layer and the silicon nitride film layer that are stacked in sequence. Details are not limited here.

### Embodiment II

Referring to Fig. 2, a solar cell according to an embodiment of the present disclosure includes:
a silicon substrate 1, including a first region 111 and a second region 121, wherein the first region 111 and the second region 121 are respectively located on two opposite surfaces of the silicon substrate 1;
a P-type doped polysilicon layer 2, at least formed on the first region 111; and
an N-type doped polysilicon layer 3, at least formed on the second region 121.

Both the P-type doped polysilicon layer 2 and the N-type doped polysilicon layer 3 contain metal impurities. The metal impurities include at least one of iron, copper, cobalt, nickel, and chromium. The N-type doped polysilicon layer 3 includes a first portion 31 close to the silicon substrate 1, and the P-type doped polysilicon layer 2 includes a third portion 21 close to the silicon substrate 1. A concentration of at least one of the metal impurities in the first portion 31 is greater than a concentration of the same metal impurity in the third portion 21.

In this embodiment of the present disclosure, the solar cell is a bifacial solar cell, and the first region 111 and the second region 121 are located on the two opposite surfaces of the silicon substrate 1. That is, the first region 111 is located on an illuminated surface of the silicon substrate 1, and the second region 121 is located on a shaded surface of the silicon substrate 1, or the first region 111 is located on a shaded surface of the silicon substrate 1, and the second region 121 is located on an illuminated surface of the silicon substrate 1.

In this embodiment of the present disclosure, the N-type doped polysilicon layer 3 is divided in its thickness direction into a first portion 31 close to the silicon substrate 1 and a second portion 32 away from the silicon substrate 1. The P-type doped polysilicon layer 2 is divided in its thickness direction into a third portion 21 close to the silicon substrate 1 and a fourth portion 22 away from the silicon substrate 1. The dashed line L3 in Fig. 2 is only to distinguish the first portion 31 and the second portion 32 of the N-type doped polysilicon layer 3, and the dashed line L4 is to distinguish the third portion 21 and the fourth portion 22 of the P-type doped polysilicon layer 2. The dashed line L3 and the dashed line L4 in Fig. 2 do not actually exist.

In some implementations, the thickness of the first portion 31 of the N-type doped polysilicon layer 3 and the thickness of the second portion 32 of the N-type doped polysilicon layer 3 are equal. In some other implementations, the thickness of the first portion 31 of the N-type doped polysilicon layer 3 and the thickness of the second portion 32 of the N-type doped polysilicon layer 3 are not equal, and specific thicknesses of the first portion 31 and the second portion 32 are not limited. In some implementations, the thickness of the third portion 21 of the P-type doped polysilicon layer 2 and the thickness of the fourth portion 22 of the P-type doped polysilicon layer 2 are equal. In some other implementations, the thickness of the third portion 21 of the P-type doped polysilicon layer 2 and the thickness of the fourth portion 22 of the P-type doped polysilicon layer 2 are not equal, and specific thicknesses of the third portion 21 and the fourth portion 22 are not limited.

In this embodiment of the present disclosure, both the P-type doped polysilicon layer 2 and the N-type doped polysilicon layer 3 contain metal impurities. The metal impurities include at least one of iron, copper, cobalt, nickel, and chromium. A concentration of at least one of the metal impurities in the first portion 31 is greater than a concentration of the same metal impurity in the third portion 21. It can be understood that when the same metal impurities in the first portion 31 and the third portion 21 are compared, a concentration of at least one metal impurity in the first portion 31 is greater than a concentration of the corresponding same metal impurity in the third portion 21. For example, the concentration of the iron in the first portion 31 is greater than the concentration of the iron in the third portion 21, the concentration of the copper in the first portion 31 is greater than the concentration of the copper in the third portion 21, the concentration of the nickel in the first portion 31 is greater than the concentration of the nickel in the third portion 21. In some implementations, the concentrations of the various metal impurities in the first portion 31 are greater than the concentrations of the same metal impurities in the third portion 21. That is, the concentration of each metal impurity in the first portion 31 is greater than the concentration of the metal impurity in the third portion 21.

In this embodiment of the present disclosure, since the metal impurities such as iron, copper, cobalt, nickel, and chromium in the silicon substrate 1 have a smaller impact on the N-type doped polysilicon layer 3 than the P-type doped polysilicon layer 2, an impurity absorption effect on the silicon substrate 1 can be improved by increasing an impurity absorption effect of the N-type doped polysilicon layer 3. That is, an impurity absorption ability of the N-type doped polysilicon layer 3 on the silicon substrate 1 is higher than an impurity absorption ability of the P-type doped polysilicon layer, so that the concentration of the same metal impurity in the N-type doped polysilicon layer 3 is greater than the concentration of the same metal impurity in the P-type doped polysilicon layer 2. Therefore, the concentrations of the metal impurities in the first portion 31 of the N-type doped polysilicon layer 3 are greater than the concentrations of the metal impurities in the third portion 21 of the P-type doped polysilicon layer 2. It is conductive to prolonging the minority carrier lifetime of the cell, thereby improving cell efficiency.

In this embodiment of the present disclosure, the impurity absorption effect of the N-type doped polysilicon layer 3 can be enhanced specifically by adjusting a doping concentration of the N-type doped polysilicon layer 3, a doping diffusion temperature of the N-type doped polysilicon layer 3, a thickness of the N-type doped polysilicon layer 3, a grain size of the N-type doped polysilicon layer 3, or the like, so that the impurity absorption effect of the N-type doped polysilicon layer 3 is better than the impurity absorption effect of the P-type doped polysilicon layer 2, and the concentrations of the metal impurities in the first portion 31 of the N-type doped polysilicon layer 3 are greater than the concentrations of the metal impurities in the third portion 21 of the P-type doped polysilicon layer 2. That is, more metal impurities such as iron, copper, cobalt, nickel, and chromium in the silicon substrate 1 enter the N-type doped polysilicon layer 3, so that the adverse effect of the metal impurities on the N-type doped polysilicon layer 3 and the P-type doped polysilicon layer 2 is reduced, and it is conductive to absorption of the doped polysilicon layers on the metal impurities in the silicon substrate 1, thereby prolonging the minority carrier lifetime of the cell and improving cell efficiency.

In some embodiments of the present disclosure, the silicon substrate 1 includes a first surface 11 and a second surface 12 opposite to the first surface 11. The first surface 11 is arranged with a plurality of the first regions 111 and a plurality of third regions 112. The first region 111 and the third region 112 are alternately arranged in sequence. The second surface 12 is arranged with a plurality of the second regions 121 and a plurality of fourth regions 122. The second region 121 and the fourth region 122 are alternately arranged in sequence. The P-type doped polysilicon layer 2 is arranged on the first regions 111 and does not cover the third regions 112; and the N-type doped polysilicon layer 3 is arranged on the second regions 121 and does not cover the fourth regions 122.

In this embodiment, one of the first surface 11 and the second surface 12 is the illuminated surface of the solar cell, and the other one is the shaded surface of the solar cell.

In this embodiment, the P-type doped polysilicon layer 2 only covers the first regions 111 of the first surface 11 and does not cover the third regions 112, and the N-type doped polysilicon layer 3 only covers the second regions 121 of the second surface 12 and does not cover the fourth regions 122. The first surface 11 of the silicon substrate 1 is not completely covered by the P-type doped polysilicon layer 2, and the second surface 12 of the silicon substrate 1 is not completely covered by the N-type doped polysilicon layer 3 either, so that this can effectively reduce the parasitic absorption of light by the P-type doped polysilicon layer 2 and the N-type doped polysilicon layer 3, and improve conversion efficiency.

Except for this embodiment, in some implementations, the first region 111 covers the entire first surface 11, and in some other implementations, the second region 121 covers the entire second surface 12.

In some embodiments of the present disclosure, a sum of areas of all N-type doped polysilicon layers 3 is greater than a sum of the areas of all P-type doped polysilicon layers 2.

A sum of areas of all the second regions 121 is greater than a sum of areas of all the first regions 111. It is conductive to enlarging a total area of the N-type doped polysilicon layer 3, thereby improving the impurity absorption ability of the N-type doped polysilicon layer 3 and improving cell efficiency.

In some embodiments of the present disclosure, the N-type doped polysilicon layer 3 includes a second portion 32 away from the silicon substrate 1. The P-type doped polysilicon layer 2 includes a fourth portion 22 close to the silicon substrate 1. A concentration of at least one of the metal impurities in the second portion 32 is greater than a concentration of the same metal impurity in the fourth portion 22.

In this embodiment, the concentration of the at least one of the metal impurities in the second portion 32 is greater than the concentration of the same metal impurity in the fourth portion 22. It can be understood that when the same metal impurities in the second portion 32 and the fourth portion 22 are compared, the concentration of the at least one of the metal impurities in the second portion 32 is greater than the concentration of the corresponding same metal impurity in the fourth portion 22. For example, the concentration of the iron in the second portion 32 is greater than the concentration of the iron in the fourth portion 22, the concentration of the copper in the second portion 32 is greater than the concentration of the copper in the fourth portion 22, the concentration of the nickel in the second portion 32 is greater than the concentration of the nickel in the fourth portion 22. In some implementations, the concentrations of the various metal impurities in the second portion 32 are greater than the concentrations of the same metal impurities in the fourth portion 22. That is, the concentration of each metal impurity in the second portion 32 is greater than the concentration of the metal impurity in the fourth portion 22.

In this embodiment, since the impurity absorption effect of the N-type doped polysilicon layer 3 is better than the impurity absorption effect of the P-type doped polysilicon layer 2, the concentrations of the metal impurities in the second portion 32 of the N-type doped polysilicon layer 3 are also greater than the concentrations of the metal impurities in the fourth portion 22 of the P-type doped polysilicon layer 2. This can further enhance the impurity absorption effect of the N-type doped polysilicon layer 3.

In some embodiments of the present disclosure, the concentration of the at least one of the metal impurities in the first portion 31 is greater than the concentration of the same metal impurity in the second portion 32.

In this embodiment, the concentration of the at least one of the metal impurities in the first portion 31 is greater than the concentration of the same metal impurity in the second portion 32. It can be understood that when the same metal impurities in the first portion 31 and the second portion 32 are compared, the concentration of at least one of the metal impurities in the first portion 31 is greater than the concentration of the corresponding same metal impurity in the second portion 32. For example, the concentration of the iron in the first portion 31 is greater than the concentration of the iron in the second portion 32, the concentration of the copper in the first portion 31 is greater than the concentration of the copper in the second portion 32, the concentration of the nickel in the first portion 31 is greater than the concentration of the nickel in the second portion 32. In some implementations, the concentrations of the various metal impurities in the first portion 31 are greater than the concentrations of the same metal impurities in the second portion 32. That is, the concentration of each metal impurity in the second portion 32 is greater than the concentration of the metal impurity in the second portion 32.

In this embodiment, since the first portion 31 of the N-type doped polysilicon layer 3 is closer to the silicon substrate 1 than the second portion 32, the concentrations of the metal impurities in the first portion 31 are greater than the concentrations of the metal impurities in the second portion 32 of the N-type doped polysilicon layer 3.

In some embodiments of the present disclosure, the concentration of the at least one of the metal impurities in the third portion 21 is greater than the concentration of the same metal impurity in the fourth portion 22.

In this embodiment, the concentration of the at least one of the metal impurities in the third portion 21 is greater than the concentration of the same metal impurity in the fourth portion 22. It can be understood that when the same metal impurities in the third portion 21 and the fourth portion 22 are compared, the concentration of the at least one of the metal impurities in the second portion 21 is greater than the concentration of the corresponding same metal impurity in the fourth portion 22. For example, the concentration of the iron in the third portion 21 is greater than the concentration of the iron in the fourth portion 22, the concentration of the copper in the third portion 21 is greater than the concentration of the copper in the fourth portion 22, the concentration of the nickel in the third portion 21 is greater than the concentration of the nickel in the fourth portion 22. In some implementations, the concentrations of the various metal impurities in the third portion 21 are greater than the concentrations of the same metal impurities in the fourth portion 22. That is, the concentration of each metal impurity in the third portion 21 is greater than the concentration of the metal impurity in the fourth portion 22.

In this embodiment, since the third portion 21 of the P-type doped polysilicon layer 2 is closer to the silicon substrate 1 than the fourth portion 22, the concentrations of the metal impurities in the third portion 21 are greater than the concentrations of the metal impurities in the fourth portion 22.

In some embodiments of the present disclosure, the concentration of the metal impurities in the first portion 31 of the N-type doped polysilicon layer 3 is 0.1 to 100 PPBW.

In some implementations, the concentrations of the metal impurities are measured by using an inductively coupled plasma mass spectrometry (ICP-MS).

In this embodiment, the concentrations of the metal impurities in the first portion 31 of the N-type doped polysilicon layer 3 are 0.1-100 PPBW. It can be understood that the concentrations of the various metal impurities in the first portion 31 of the N-type doped polysilicon layer 3 are 0.1 to 100 PPBW. The metal impurities such as iron, copper, cobalt, nickel, and chromium in the silicon substrate 1 enter the N-type doped polysilicon layer 3, and the concentrations of the metal impurities in the N-type doped polysilicon layer 3 are 0.1 to 100 PPBW.

In some embodiments of the present disclosure, the concentration of the metal impurities in the first portion 31 of the N-type doped polysilicon layer 3 is 10 to 100 PPBW.

In this embodiment, the metal impurities such as iron, copper, cobalt, nickel, and chromium in the silicon substrate 1 enter the N-type doped polysilicon layer 3, and the concentrations of the metal impurities in the N-type doped polysilicon layer 3 are 10 to 100 PPBW. This further increases the concentrations of the metal impurities in the N-type doped polysilicon layer 3 and improves the impurity absorption ability of the N-type doped polysilicon layer 3.

In some embodiments of the present disclosure, the concentration of the metal impurities in the first portion 31 of the N-type doped polysilicon layer 3 is 30 to 100 PPBW.

In this embodiment, the concentrations of the metal impurities in the N-type doped polysilicon layer 3 are further increased, and the impurity absorption ability of the N-type doped polysilicon layer 3 is further improved.

In some embodiments of the present disclosure, the concentration of the metal impurities in the first portion 31 of the N-type doped polysilicon layer 3 is 1 × 10¹¹ ~ 8 × 10¹³ atoms/cm³. In some implementations, the concentrations that represent the metal impurities are measured by using a secondary ion mass spectrometry (SIMS) or another higher-precision measuring instrument.

In this embodiment, the concentration of the metal impurities in the first portion 31 of the N-type doped polysilicon layer 3 is 1 × 10¹¹ ~ 8 × 10¹³ atoms/cm³. It can be understood that the concentrations of the various metal impurities in the first portion 31 of the N-type doped polysilicon layer 3 are within a range of 1 × 10¹¹ ~ 8 × 10¹³ atoms/cm³. The metal impurities such as iron, copper, cobalt, nickel, and chromium in the silicon substrate 1 enter the first portion 31 of the N-type doped polysilicon layer 3, so that the concentrations of the metal impurities in the first portion 31 of the N-type doped polysilicon layer 3 are 1 × 10¹¹ ~ 8 × 10¹³ atoms/cm³.

In some embodiments of the present disclosure, the concentration of the metal impurities in the third portion 21 of the P-type doped polysilicon layer 2 is 0.6×10¹¹ ~ 5×10¹³ atoms/cm³. In some implementations, the concentrations that represent the metal impurities are measured by using a secondary ion mass spectrometry (SIMS) or another higher-precision measuring instrument.

The metal impurities such as iron, copper, cobalt, nickel, and chromium in the silicon substrate 1 enter the third portion 21 of the P-type doped polysilicon layer 2, so that the concentrations of the metal impurities in the third portion 21 of the P-type doped polysilicon layer 2 are 0.6×10¹¹ ~ 5×10¹³ atoms/cm³.

In some embodiments of the present disclosure, the concentration of the at least one of the metal impurities in the first portion 31 is greater than the concentration of the same metal impurity in the silicon substrate 1.

In this embodiment, the concentration of the at least one of the metal impurities in the first portion 31 is greater than the concentration of the same metal impurity in the silicon substrate 1. It can be understood that when the same metal impurities in the first portion 31 and the silicon substrate 1 are compared, the concentration of at least one of the metal impurities in the first portion 31 is greater than the concentration of this metal impurity in the silicon substrate 1. For example, the concentration of the iron in the first portion 31 is greater than the concentration of the iron in the silicon substrate 1, the concentration of the copper in the first portion 31 is greater than the concentration of the copper in the silicon substrate 1, the concentration of the nickel in the first portion 31 is greater than the concentration of the nickel in the silicon substrate 1. In some implementations, the concentrations of the various metal impurities in the first portion 31 are greater than the concentrations of the same metal impurities in the silicon substrate 1. That is, the concentration of each metal impurity in the first portion 31 is greater than the concentration of the metal impurity in the silicon substrate 1. That is, more metal impurities in the silicon substrate 1 are absorbed into the N-type doped polysilicon layer 3, thus achieving a good impurity absorption effect on the silicon substrate 1.

In some embodiments of the present disclosure, a ratio of a concentration of a metal impurity in the first portion 31 to a concentration of the same metal impurity in the third portion 21 is 1.5 to 100.

In this embodiment, the ratio of the concentration of the metal impurity in the first portion 31 to the concentration of the same metal impurity in the third portion 21 is 1.5 to 100. It can be understood that when the same metal impurities in the first portion 31 and the third portion 21 are compared, the ratio of the concentration of the metal impurity in the first portion 31 to the concentration of the metal impurity in the third portion 21 is 1.5 to 100. Therefore, the impurity absorption ability of the N-type doped polysilicon layer 3 is 1.5 to 100 times the impurity absorption ability of the P-type doped polysilicon layer 2, thereby effectively improving the impurity absorption ability of the N-type doped polysilicon layer 3 compared with the impurity absorption ability of the P-type doped polysilicon layer 2.

Further, the ratio of the concentration of the metal impurity in the first portion 31 to the concentration of the same metal impurity in the third portion 21 is 10 to 100.

In some implementations, a ratio of a concentration of a metal impurity in the first portion 31 to a concentration of the same metal impurity in the third portion 21 is 50 to 100.

In some embodiments of the present disclosure, the solar cell further includes:
a first tunneling layer 4, provided between the silicon substrate 1 and the P-type doped polysilicon layer 2; and
a second tunneling layer 5, provided between the silicon substrate 1 and the N-type doped polysilicon layer 3, wherein a thickness of the second tunneling layer 5 is less than a thickness of the first tunneling layer 4.

In this embodiment, the first tunneling layer 4 and the second tunneling layer 5 achieve tunneling passivation, which can improve cell efficiency. Since the thickness of the second tunneling layer 5 is less than the thickness of the first tunneling layer 4, it is advantageous for more impurities in the silicon substrate 1 to enter the N-type doped polysilicon layer 3 through the second tunneling layer 5, thereby enhancing the impurity absorption effect.

In some embodiments of the present disclosure, the thickness of the second tunneling layer 5 is 0.1 to 0.9 times the thickness of the first tunneling layer 4.

In this embodiment, the thickness of the second tunneling layer 5 is 0.1 to 0.9 times the thickness of the first tunneling layer 4. This not only facilitates the impurities in the silicon substrate 1 to enter the N-type doped polysilicon layer 3 through the second tunneling layer 5, but also makes the second tunneling layer 5 and the first tunneling layer 4 maintain good tunneling passivation.

In some embodiments of the present disclosure, both the second tunneling layer 5 and the first tunneling layer 4 have pores, and a pore density of the second tunneling layer 5 is greater than a pore density of the first tunneling layer 4.

In this embodiment, the pore density of the second tunneling layer 5 is greater than the pore density of the first tunneling layer 4, so that it can be understood that a quantity of the pores in the second tunneling layer 5 is greater than a quantity of the pores in the first tunneling layer 4 per unit area. Since the pore density of the second tunneling layer 5 is less than the pore density of the first tunneling layer 4, it can be more convenient for the impurities to enter the N-type doped polysilicon layer 3 through the second tunneling layer 5, and it is conductive to enhancing the impurity absorption effect of the N-type doped polysilicon layer 3 and improving cell efficiency.

In some embodiments of the present disclosure, both the second tunneling layer 5 and the first tunneling layer 4 have pores, and an average size of the pores in the second tunneling layer 5 is greater than an average size of the pores in the first tunneling layer 4.

In some implementations, pore diameters of the pores in the second tunneling layer 5 are equal. In some other implementations, pore diameters of the pores in the second tunneling layer 5 are not equal. Similarly, in some implementations, pore diameters of the pores in the first tunneling layer 4 are equal. In some other implementations, pore diameters of the pores in the first tunneling layer 4 are not equal. An average pore diameter of the pores in the second tunneling layer 5 can be understood as an average pore diameter of all the pores in the second tunneling layer 5. An average pore diameter of the pores in the first tunneling layer 4 can be understood as an average pore diameter of all the pores in the first tunneling layer 4. Since the average pore diameter of the second tunneling layer 5 is set to be greater than the average pore diameter of the first tunneling layer 4, it is convenient for the impurities to enter the N-type doped polysilicon layer 3 through the second tunneling layer 5, and it is conductive to enhancing the impurity absorption effect of the N-type doped polysilicon layer 3 and improving cell efficiency.

In some embodiments of the present disclosure, an area of the N-type doped polysilicon layer 3 is larger than an area of the P-type doped polysilicon layer 2.

In this embodiment, since the area of the N-type doped polysilicon layer 3 is larger than the area of the P-type doped polysilicon layer 2, a region of the silicon substrate 1 covered by the N-type doped polysilicon layer 3 can be enlarged. It is convenient for more impurities in the silicon substrate 1 to enter the N-type doped polysilicon layer 3, thereby enhancing the impurity absorption effect of the N-type doped polysilicon layer 3 and improving cell efficiency.

In some embodiments of the present disclosure, the area of the N-type doped polysilicon layer 3 is 1 to 10 times the area of the P-type doped polysilicon layer 2.

In this embodiment, the area of the N-type doped polysilicon layer 3 is a total area of all N-type doped polysilicon layers 3, and the area of the P-type doped polysilicon layer 2 is a total area of all P-type doped polysilicon layers 2. In some other implementations, the area of the N-type doped polysilicon layer 3 is an area of a single N-type doped polysilicon layer 3, and the area of the P-type doped polysilicon layer 2 is an area of a single P-type doped polysilicon layer 2.

In some implementations, a ratio of the area of the N-type doped polysilicon layer 3 to the area of the P-type doped polysilicon layer 2 is: 1.01, or 1.5, or 2.0, or 2.4, or 3.0, or 3.5, or 4, or 4.5, or 5, or 5.5, or 6, or 6.5, or 7, or 7.5, or 8, or 8.5, or 9, or 9.5, or 10.

In a preferred embodiment of the present disclosure, the area of the N-type doped polysilicon layer 3 is 3 to 10 times the area of the P-type doped polysilicon layer 2. This can further increase a difference between the area of the N-type doped polysilicon layer 3 and the area of the P-type doped polysilicon layer 2, and is conductive to enhancing the impurity absorption effect of the N-type doped polysilicon layer 3.

In some embodiments of the present disclosure, a width of the N-type doped polysilicon layer 3 is greater than a width of the P-type doped polysilicon layer 2.

In this embodiment, a length of each N-type doped polysilicon layer 3 is equal to a length of each P-type doped polysilicon layer 2, and the width of each N-type doped polysilicon layer 3 is greater than the width of each P-type doped polysilicon layer 2. Therefore, the area of the N-type doped polysilicon layer 3 is larger than the area of the P-type doped polysilicon layer 2, so that a region of the silicon substrate 1 covered by the N-type doped polysilicon layer 3 can be enlarged. It is convenient for more impurities in the silicon substrate 1 to enter the N-type doped polysilicon layer 3, thereby enhancing the impurity absorption effect of the N-type doped polysilicon layer 3 and improving cell efficiency.

In some embodiments of the present disclosure, a thickness of the N-type doped polysilicon layer 3 is greater than a thickness of the P-type doped polysilicon layer 2.

In this embodiment, thicknesses of the N-type doped polysilicon layers 3 are equal, and thicknesses of the P-type doped polysilicon layers 2 are equal. Since the thickness of the N-type doped polysilicon layer 3 is greater than the thickness of the P-type doped polysilicon layer 2, a total volume of the N-type doped polysilicon layer 3 can be increased, thereby further improving the impurity absorption ability of the N-type doped polysilicon layer. It is convenient for more impurities in the silicon substrate 1 to enter the N-type doped polysilicon layer 3, thereby enhancing the impurity absorption effect of the N-type doped polysilicon layer 3 and improving cell efficiency.

In some embodiments of the present disclosure, the thickness of the N-type doped polysilicon layer 3 is 1 to 10 times the thickness of the P-type doped polysilicon layer 2.

In this embodiment, a ratio of the thickness of the N-type doped polysilicon layer 3 to the thickness of the P-type doped polysilicon layer 2 is: 1.01, or 1.5, or 2.0, or 2.4, or 3.0, or 3.5, or 4, or 4.5, or 5, or 5.5, or 6, or 6.5, or 7, or 7.5, or 8, or 8.5, or 9, or 9.5, or 10.

In a preferred embodiment of the present disclosure, the thickness of the N-type doped polysilicon layer 3 is 3 to 10 times the thickness of the P-type doped polysilicon layer 2, which can further increase a difference between the thickness of the N-type doped polysilicon layer 3 and the thickness of the P-type doped polysilicon layer 2, and is conductive to enhancing the impurity absorption effect of the N-type doped polysilicon layer 3.

In some embodiments of the present disclosure, a volume of each N-type doped polysilicon layer 3 is greater than a volume of each P-type doped polysilicon layer 2, so that it is conductive to increasing a total volume of the N-type doped polysilicon layer 3, to improve the impurity absorption ability of the N-type doped polysilicon layer 3, and it is conductive to improving cell efficiency.

In some embodiments of the present disclosure, the solar cell further includes:
a first electrode 6, which is in contact with the P-type doped polysilicon layer 2; and
a second electrode 7, which is in contact with the N-type doped polysilicon layer 3.

In some embodiments of the present disclosure, the solar cell further includes:
a first passivation layer 9 that covers the P-type doped polysilicon layer 2, wherein the first electrode 6 is in contact with the P-type doped polysilicon layer 2 through the first passivation layer 9; and
a second passivation layer 10 that covers the N-type doped polysilicon layer 3, wherein the second electrode 7 is in contact with the N-type doped polysilicon layer 3 through the second passivation layer 10.

In this embodiment, both the first passivation layer 9 and the second passivation layer 10 can include at least one of or a combination of more of an aluminum oxide film layer, a silicon oxide film layer, a silicon nitride film layer, a silicon carbide film layer, and a silicon nitride oxide film layer. For example, in some embodiments, the first passivation layer 9 and the second passivation layer 10 can include the aluminum oxide film layer and the silicon nitride film layer that are stacked in sequence. Details are not limited here.

### Embodiment 3

An embodiment of the present disclosure further provides a cell module. The cell module includes the solar cell as described in Embodiment I or Embodiment II. It should be noted that the cell module has the same or similar beneficial effects as or to the solar cell, and the cell module and the solar cell can be referred to each other. To avoid repetition, no further elaboration will be provided here.

### Embodiment 4

An embodiment of the present disclosure further provides a photovoltaic system, including the cell module as described in Embodiment III. It should be noted that the photovoltaic system has the same or similar beneficial effects as or to the solar cell, and the cell module and the solar cell can be referred to each other. To avoid repetition, no further elaboration will be provided here.

According to the solar cell provided by the embodiments of the present disclosure, the concentration of at least one metal impurity in the first portion of the N-type doped polysilicon layer close to the silicon substrate is greater than the concentration of the same metal impurity in the third portion of the P-type doped polysilicon layer close to the silicon substrate. That is, metal impurities entering the first portion of the N-type doped polysilicon layer from the silicon substrate are more than metal impurities entering the third portion of the P-type doped polysilicon layer from the silicon substrate, so that an impurity absorption effect of the N-type doped polysilicon layer on the silicon substrate is better than an impurity absorption effect of the P-type doped polysilicon layer. This can reduce an adverse effect caused by the metal impurities in the silicon substrate on the N-type doped polysilicon layer and the P-type doped polysilicon layer, and it is convenient for the doped polysilicon layer to absorb the metal impurities in the silicon substrate and is conductive to prolonging the minority carrier lifetime of the cell, thereby improving cell efficiency.

The foregoing descriptions are merely preferred embodiments of the present disclosure, but are not intended to limit present disclosure. Any modification, equivalent replacement, or improvement made within the spirit and principle of present disclosure shall fall within the protection scope of the present disclosure.

## Claims

1. A solar cell, comprising:
a silicon substrate, comprising a first region and a second region, wherein the first region and the second region are located on a same surface of the silicon substrate, or the first region and the second region are respectively located on two opposite surfaces of the silicon substrate;
a P-type doped polysilicon layer, at least formed on the first region; and
an N-type doped polysilicon layer, at least formed on the second region,
wherein both the P-type doped polysilicon layer and the N-type doped polysilicon layer contain metal impurities; the metal impurities comprise at least one of iron, copper, cobalt, nickel, and chromium; the N-type doped polysilicon layer comprises a first portion close to the silicon substrate, and the P-type doped polysilicon layer comprises a third portion close to the silicon substrate; and a concentration of at least one of the metal impurities in the first portion is greater than a concentration of a same metal impurity in the third portion.

2. The solar cell according to claim 1, wherein the N-type doped polysilicon layer comprises a second portion away from the silicon substrate, and the P-type doped polysilicon layer comprises a fourth portion away from the silicon substrate; and a concentration of at least one of the metal impurities in the second portion is greater than a concentration of a same metal impurity in the fourth portion.

3. The solar cell according to claim 2, wherein a concentration of the at least one of the metal impurities in the first portion is greater than a concentration of a same metal impurity in the second portion.

4. The solar cell according to claim 2, wherein a concentration of the at least one of the metal impurities in the third portion is greater than a concentration of a same metal impurity in the fourth portion.

5. The solar cell according to claim 1, wherein a concentration of the metal impurities in the first portion of the N-type doped polysilicon layer is 0.1 to 100 PPBW.

6. The solar cell according to claim 1, wherein the concentration of the metal impurities in the first portion of the N-type doped polysilicon layer is 10 to 100 PPBW.

7. The solar cell according to claim 1, wherein the concentration of the metal impurities in the first portion of the N-type doped polysilicon layer is 30 to 100 PPBW.

8. The solar cell according to claim 1, wherein the concentration of the at least one of the metal impurities in the first portion is greater than a concentration of a same metal impurity in the silicon substrate.

9. The solar cell according to claim 1, wherein a ratio of a concentration of a metal impurity in the first portion to a concentration of the same metal impurity in the third portion is 1.5 to 100.

10. The solar cell according to claim 1, further comprising:
a first tunneling layer, provided between the silicon substrate and the P-type doped polysilicon layer; and
a second tunneling layer, provided between the silicon substrate and the N-type doped polysilicon layer,
wherein a thickness of the second tunneling layer is less than a thickness of the first tunneling layer.

11. The solar cell according to claim 10, wherein the thickness of the second tunneling layer is 0.1 to 0.9 times the thickness of the first tunneling layer.

12. The solar cell according to claim 10, wherein both the second tunneling layer and the first tunneling layer have pores, and a pore density of the second tunneling layer is greater than a pore density of the first tunneling layer.

13. The solar cell according to claim 10, wherein both the second tunneling layer and the first tunneling layer have pores, and an average size of the pores in the second tunneling layer is greater than an average size of the pores in the first tunneling layer.

14. The solar cell according to claim 1, wherein an area of the N-type doped polysilicon layer is larger than an area of the P-type doped polysilicon layer.

15. The solar cell according to claim 1, wherein the area of the N-type doped polysilicon layer is 1 to 10 times the area of the P-type doped polysilicon layer.

16. The solar cell according to claim 1, wherein a thickness of the N-type doped polysilicon layer is greater than a thickness of the P-type doped polysilicon layer.

17. The solar cell according to claim 1, wherein the thickness of the N-type doped polysilicon layer is 1 to 10 times the thickness of the P-type doped polysilicon layer.

18. The solar cell according to claim 1, wherein the solar cell is a back-contact solar cell, and the first region and the second region are located on the same surface of the silicon substrate.

19. The solar cell according to claim 1, wherein the solar cell is a bifacial solar cell, and the first region and the second region are respectively located on two opposite surfaces of the silicon substrate.

20. The solar cell according to claim 19, wherein the silicon substrate comprises a first surface and a second surface opposite to the first surface; the first surface is arranged with a plurality of the first regions and a plurality of third regions; the first region and the third region are alternately arranged in sequence; the second surface is arranged with a plurality of the second regions and a plurality of fourth regions; the second region and the fourth region are alternately arranged in sequence; the P-type doped polysilicon layer is arranged on the first regions and does not cover the third regions; and the N-type doped polysilicon layer is arranged on the second regions and does not cover the fourth regions.

21. A cell module, comprising the solar cell according to any one of claims 1 to 20.

22. A photovoltaic system, comprising the cell module according to claim 21.
